# EUROPEAN PATENT APPLICATION

(11) **EP 2 615 646 A1**
(43) Date of publication of application: **17.07.2013**
(21) Application number: 11823534.0
(22) Date of filing: 05.09.2011
(51) Int. Cl.: H01L 31/042

(54) **PROCESS FOR MANUFACTURE OF SOLAR BATTERY MODULE, SOLAR BATTERY CELL CONNECTION DEVICE, AND SOLAR BATTERY MODULE**

(30) Priority: 07.09.2010 JP 2010199968
(71) Applicant: Dexerials Corporation, Tokyo 141-0032 (JP)
(72) Inventor: FUJII, Takahiro, Tokyo 141-0032 (JP); SUGA, Yasuhiro, Tokyo 141-0032 (JP)
(74) Representative: Müller - Hoffmann & Partner
(86) International application number: PCT/JP2011/070184
(87) International publication number: WO 2012/033059

(57) **Abstract**

A method for producing a solar cell module is disclosed in which, in a step of bonding a tab wire to a given solar cell via an electrically conductive adhesive film, it is possible to prevent that the connection strength of the electrically conductive adhesive film to another solar cell to be connected to the tab wire is lowered. In the method for producing a solar cell module, a front surface electrode (11) of a given solar cell (2) and a reverse surface electrode (13) of another solar cell (2) are interconnected by a tab wire (3) affixed to the front surface electrode (11) and the reverse surface electrode (13) via thermally curable electrically conductive adhesive films (15). The method includes a placing step of placing the electrically conductive adhesive film (15) and the tab wire (3) on top of the front surface electrode (11) and the reverse surface electrode (13), and a thermal pressuring step of pressuring a first adherent portion (3a) of the tab wire (3) placed on one of the electrodes by a first pressuring head (22) having a heating/ pressuring unit. The method also includes a heat dissipating step of pressuring a second adherent portion (3b) of the tab wire (3), placed on the other electrode, by a second pressuring head (23) having a heat dissipating unit.

## Description

### Field of the Invention

This invention relates to a device for interconnecting a plurality of solar cells by a tab wire, a method for producing a solar cell module using the interconnecting device, and to the solar cell module.
The present application asserts priority rights based on JP Patent Application 2010-199968 filed in Japan on September 7, 2010. The total contents of disclosure of the Patent Application of the senior filing date are to be incorporated by reference into the present Application.

### Background of the Invention

A solar cell is attracting notice as a new energy source benign to environments because it is able to directly convert the solar energy, which is clean and abundant, into electricity. However, in using solar cells as power supply source, the output per solar cell is on the order of several W, and hence the cells may not be used alone. Instead, a plurality of solar cells is connected in cascade for use as a solar cell module in which the output is raised to 100 W or more.

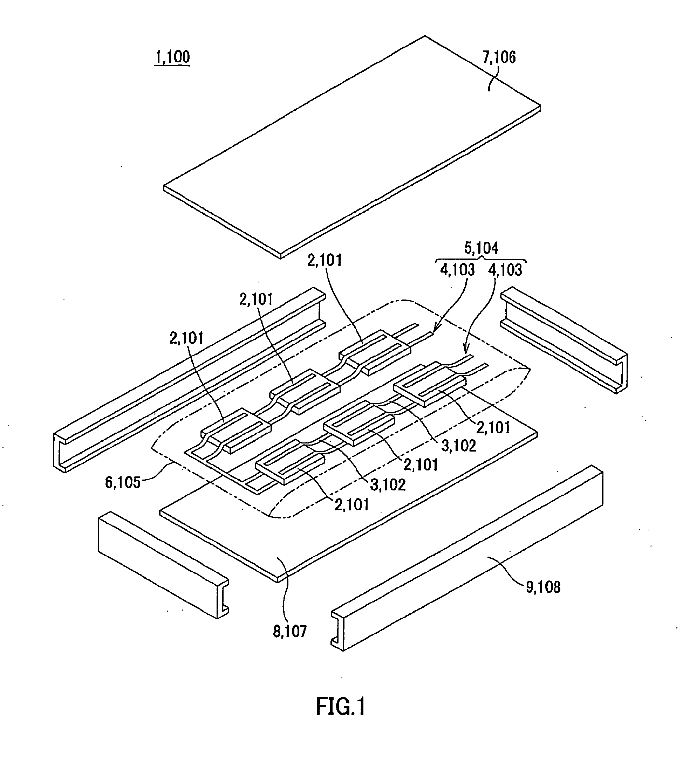

For example, in a solar cell module 100 of the crystalline silicon system, a plurality of neighbored solar cells 101 is interconnected by a solder-coated ribbon-shaped tab wire 102 made of copper foil to form a string 103, as shown in Fig.1. A plurality of the strings 103 is arranged together to form a matrix 104. In the solar cell module 100, the matrix 104 is covered by a sheet 105 of a sealant adhesive and is laminated in a lump together with a front side protective cover 106 and a back sheet 107 to form an assembly. The front side protective cover 106 is arranged on a light receiving side and the back sheet 107 is arranged on a reverse side. Finally, a metal frame 108 of, for example, aluminum, is fitted on lateral sides of the assembly to complete the solar cell module.

The interconnection of the solar cells 101 and the tab wire 102 is by processing of soldering of a bus-bar electrode, an Ag electrode and the tab wire 102 (Patent Document 1). The bus-bar electrode is formed by screen printing of silver paste on a light receiving surface of the solar cell 101, while the Ag electrode is formed on a connecting part of its reverse surface (see Patent Document 1). Note that an Al electrode is formed in an area other than the connecting part of the reverse surface of the solar cell 101.

However, the processing for interconnection by soldering is carried out at an elevated temperature of approximately 260°C. It is thus feared that the interconnection of front and reverse surface electrodes and the tab wire 102 is lowered in reliability due to warping of the solar cell 101, the internal stress generated in the interconnection between the tab wire 102 on one hand and the front and reverse surface electrodes on the other, or to flux residues.

Thus, in the conventional solar cell 101, an electrically conductive adhesive film 110 is used for an interconnection between the front and reverse side electrodes of the solar cell 101 and the tab wire 102. With the electrically conductive adhesive film 110, it is possible to make the interconnection by thermal pressure bonding at lower temperatures (see Patent Document 2). The electrically conductive adhesive film 110 is prepared on dispersing spherically-shaped or flake-shaped electrically conductive particles, with an average particle size of the order of several µm, into a thermally curable binder resin composition and on forming the resin composition into a film. Since the film is thermally pressure bonded between two conductors, electrically conduction may be established between the conductors via the electrically conductive particles. The two conductors are also mechanically interconnected by a binder resin.

### Related Technical Documents

### Patent Documents

Patent Document 1: Japanese laid-open Patent No. 2004-356349
Patent Document 2: Japanese laid-open Patent No. 2008-135654

### Summary of the Invention

It is now assumed that the solar cell 101 and the tab wire 102 of the crystalline silicon based solar cell module 100 are to be interconnected using the electrically conductive adhesive film 110. In such case, each end of the sole tab wire 102 is temporarily pressure bonded to a connection part 111a of a reverse surface electrode 111 of a solar cell 101a and to a bus-bar electrode 112 formed on a front surface of another solar cell 101b via a electrically conductive adhesive film 110 which is in a non-cured state. The solar cell 101b is the cell neighbored to the solar cell 101a. Analogously, each end of another sole tab wire 102 is temporarily pressure bonded to a connection part 111a of a reverse surface electrode 111 of the other solar cell 101b and to a bus-bar electrode 112 formed on a front surface of a further solar cell 101c which is on the trailing side of the solar cell 101b. In this manner, contiguously arranged solar cells 101 are interconnected via a plurality of tab wires 102.

Next, the solar cells 101a, 101b, ···, interconnected by the tab wires 102, are transported until the connection part 111a of the reverse surface electrode 111 and the bus-bar electrode 112 of the leading side solar cell 101a face upper and lower pair thermal pressure bonding means 113, such as thermal pressure bonding heads.

The pair thermal pressure bonding means 113 thrust the tab wires 102, temporarily affixed to the front and reverse surface sides of the sole cell 101a, towards the bus-bar electrode 112 and towards the connection part 111a of the reverse surface electrode 111, under a pre-set pressure, such as ca. 0.5 to 3MPa. During this time, the pair thermal pressure bonding means 113 are heated to a pre-set temperature, such as ca. 180°C. This heating by the pair thermal pressure bonding means 113 induces a thermal curing reaction in the electrically conductive adhesive film 110. Thus, in the solar cell 101a, the ends of the tab wires 102 are bonded via the electrically conductive adhesive films 110 to the bus-bar electrode 112 formed on the front side electrode and to the connection part 111a of the reverse side electrode 111.

In this method of construction, heat generated by the pair thermal pressure bonding means 113 is transmitted via the tab wires 102 to the neighbored other solar cell 101b, thus inducing curing in the non-cured electrically conductive adhesive film 110 arranged in the solar cell 101b. That is, in the ultimate pressure bonding step for the tab wires 102 for the solar cell 101a, which occurs before thermal pressuring of the electrically conductive adhesive film 110 to the other solar cell 101b, the thermal curing reaction of the electrically conductive adhesive film 110, temporarily pressure bonded to the other solar cell 101 b, occurs prematurely. There is thus fear that, even though the tab wire 102 is thermally pressured against the other solar cell 101b, the adhesion strength for the other solar cell 101 b is lower than a desired value.

It is therefore an object of the present invention to provide a method for producing a solar cell module and a device for interconnection for solar cells and the solar cell module according to which, in a process of bonding a tab wire to a given solar cell by an electrically conductive adhesive film, it is possible to prevent that another electrically conductive adhesive film for another solar cell which is to be connected by the tab wire is lowered in adhesion strength to assure high connection reliability.

### Means to Solve the Problem

To accomplish the above object, the present invention provides a method for producing a solar cell module in which a front surface electrode of a given solar cell and a reverse surface electrode of another solar cell are interconnected by a tab wire affixed to the front surface electrode via a thermally curable electrically conductive adhesive film and also affixed to the reverse surface electrode via another thermally curable electrically conductive adhesive film. The method includes a placing step of placing the tab wire via the electrically conductive adhesive films on the front surface electrode and the reverse surface electrode, a thermal pressuring step of pressuring a first adherent portion of the tab wire placed on one of the electrodes via the electrically conductive adhesive film in a non-cured state, by a first pressuring head having a heating/ pressuring unit, and a heat dissipating step of pressuring a second adherent portion of the tab wire, placed on the other electrode via the other electrically conductive adhesive film in a non-cured state, by a second pressuring head having a heat dissipating unit.

The present invention also provides an apparatus for interconnecting a plurality of solar cells. The apparatus includes a support unit that supports a plurality of solar cells in cascade, and a first pressuring head including a heating/pressuring unit that heats/ thrusts one end of a tab wire temporarily affixed to a front surface electrode or a reverse surface electrode of a given solar cell via an electrically conductive adhesive film in a non-cured state. The apparatus also includes a second pressuring head including a heat dissipating unit that thrusts the opposite end of the tab wire temporarily affixed via another electrically conductive adhesive film in a non-cured state to a front surface electrode or a reverse surface electrode of another solar cell neighbored to the given solar cell to dissipate the heat.

The solar cell module according to the present invention is produced using the above mentioned producing method.

### Beneficent Result of the Invention

According to the present invention, the tab wire for the solar cell neighbored to the solar cell currently pressured by the first pressuring head is thrust by a second pressuring head. By so doing, heat by the first pressuring head is not transmitted to the electrically conductive adhesive film arranged for the other solar cell provided in rear of the first-stated solar cell thrust to prevent progressing of the curing reaction.

### Brief Description of the Drawings

Fig.1 is an exploded perspective view showing a solar cell module.
Fig.2 is a cross-sectional view showing the state of interconnection of solar cells.
Fig.3 is a schematic view showing a device for bonding an electrically conductive adhesive film to the solar cell.
Fig.4 is a side view showing an interconnection device that temporarily pressure bonds a tab wire to the solar cell.
Fig.5 is a side view showing an interconnection device that ultimately pressure bonds the tab wire to the solar cell.
Fig.6 is a schematic side view showing another heat dissipating head according to the present invention.
Fig.7 is a schematic side view showing still another heat dissipating head according to the present invention.
Fig.8 is a side view showing a sample for evaluation used in an Example of the present invention.

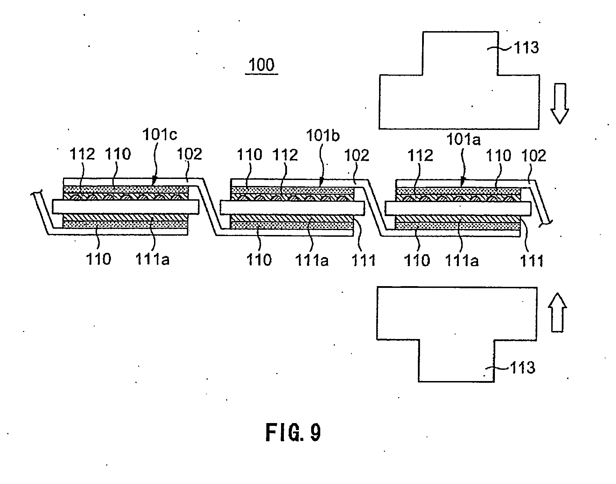

Fig.9 is a side view for illustrating the process of pressure bonding tab wires to conventional solar cells.

### Detailed Description of the Invention

A method for producing a solar cell module, a device for interconnecting a plurality of solar cells to form the solar cell module, and the solar cell module, according to the present invention, will now be described in detail with reference to the drawings.

### [Solar cell module 1]

Referring to Fig.1, a solar cell module 1, produced by the method of the present invention, includes a plurality of strings 4, each of which is composed by a plurality of solar cells 2 interconnected in cascade by a plurality of tab wires 3 operating as interconnectors. A plurality of the strings 4 are arranged together to form a matrix 5. In the solar cell module 1, the matrix 5 is covered by a sheet 6 of a sealant adhesive and is laminated in a lump together with a front side protective cover 7 and a back sheet 8 to form an assembly. It is noted that the front side protective cover 7 is arranged on a light receiving side and the back sheet 8 is arranged on a reverse side. Finally, a metal frame 9 of, for example, aluminum, is fitted on the lateral sides of the assembly to complete the solar cell module.

The sealant adhesive used may be a transparent sealant of, for example, an ethylene vinyl acetate (EVA) resin. The front cover 7 is formed of a transparent material, such as glass or a transparent resin. The back sheet 8 may be formed by a glass or an aluminum foil sandwiched between resin films.

### (Solar cell 2)

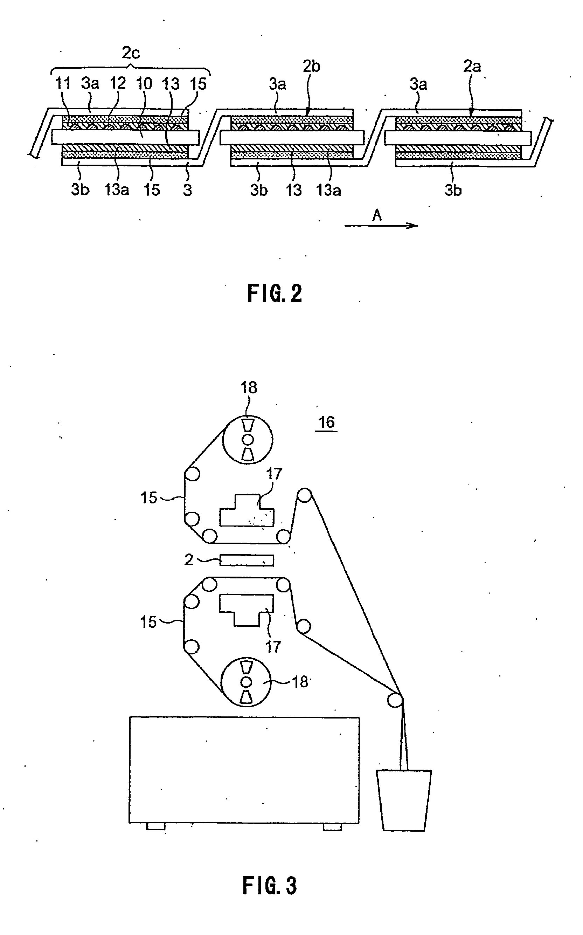

Referring to Fig.2, each solar cell 2 of the solar cell module includes a photovoltaic transducer element 10 provided with a silicon substrate. On the light receiving surface of the photovoltaic transducer element 10, there are formed a bus-bar electrode 11, operating as a front surface side electrode, and a finger electrode 12, a collecting electrode formed extending substantially at right angles to the bus-bar electrode 11. A reverse surface side electrode 13, formed of aluminum, is provided on a reverse side surface of the photovoltaic transducer element 10 opposite to its light receiving surface.

The bus-bar electrode 11 on the front surface of the solar cell 2 is electrically connected via a tab wire 3 to a reverse surface side aluminum electrode 13 of a neighbored solar cell 2, thereby forming a tandem connection of two strings 4. The interconnection between the tab wire 3 and the bus-bar electrode 11 and between the tab wire 3 and the reverse surface side aluminum electrode 13 is via electrically conductive adhesive films 15.

The tab wire 3 may be a tab wire used in a conventional solar cell module. The tab wire 3 is formed by a ribbon-shaped copper foil 50 to a thickness of 300 µm, with the use of plating with gold, silver, tin or with a solder, as necessary.

The bus-bar electrode 11 is formed by coating an Ag paste followed by heating. To reduce an area of interception of incident light and to suppress shadow loss, the bus-bar electrode 11 is formed to a line width of, for example, 1 mm. The number of the bus-bar electrodes 11 is suitably determined taking into account the size of the solar cell 2 or the resistance.

The finger electrode 12 is formed, by a method analogous to that used in forming the bus-bar electrode 11, over substantially the entire area of the light receiving surface of the solar cell 2, so that the finger electrode will intersect the bus-bar electrode. The finger electrode 12 is composed by a plurality of lines with line widths of the order of, for example, 100 µm, at preset intervals of, for example, 2 mm.

As the reverse surface side Al electrode 13, an electrode of aluminum is formed on the entire reverse side surface of the solar cell 2 by screen printing or sputtering, as shown for example in Fig.3.

The electrically conductive adhesive film 15, a thermo-curing adhesive, is cured, as the electrically conductive particles are, as it were, collapsed, as later explained, on thermal pressure bonding by a heating pressuring head 22. In this manner, the tab wire 3 is connected to the bus-bar electrode 11 and to a connecting part 13a of the reverse surface side A1 electrode 13.

Specifically, the electrically conductive adhesive film 15 is composed by electrically conductive particles, contained in an organic resin binder, which organic resin binder is composed of a film forming material, a liquid curing component, a silane coupling agent and a curing agent. The film forming material may be any suitable organic resin exhibiting a film-forming capability, such as a phenoxy resin or a solid epoxy resin. The liquid curing agent may be any compound having a thermo-curing property, such as liquid epoxy resin or liquid acrylate. In case the liquid epoxy resin is used, curing agents, such as amine-based curing agent, imidazoles, sulfonium salts or onium salts, may preferably be used. In case of using liquid acrylates, curing agents, such as thermal radical generators, including organic peroxides, may preferably be used. Inorganic fillers or a variety of additives may also be used.

The solar cell module 1 is formed by interconnecting a plurality of solar cells 2 in cascade by the tab wires 3 operating as interconnectors. More specifically, the solar cell module 1 is formed by connecting one end 3a of a tab wire 3 to the bus-bar electrode 11 formed on a light receiving surface of a solar cell 2a and by connecting the other end 3b of the tab wire 3 to the connecting part 13a of the reverse surface side Al electrode 13 formed on the reverse surface of the neighbored other solar cell 2b.

### [Temporary bonding process for the electrically conductive adhesive film 15]

As mentioned above, the interconnection between the tab wire 3 on one hand and the bus-bar electrode 11 and the reverse surface side Al electrode 13 on the other is by the electrically conductive adhesive films 15 bonded in advance on the bus-bar electrode 11 and on the reverse surface side Al electrode 13. The process of bonding the electrically conductive adhesive film 15 is by placing each solar cell 2 on a bonding device 16 for the electrically conductive adhesive film 15 and by temporarily bonding the non-cured electrically conductive adhesive films 15 on the bus-bar electrode 11 and on the connecting part 13a of the reverse surface side Al electrode 13 of the solar cell 2 by a temporary bonding head 17.

Specifically, the bonding device 16 includes a pair of supply reels 18 for supplying the electrically conductive adhesive film 15 and the paired temporary bonding heads 17 for temporary bonding the electrically conductive adhesive film 15 at pre-set positions on both surface sides of the solar cell 2, as shown in Fig.3. The bonding device 16 includes the temporary bonding heads 17 and the supply reels 18 on upper and lower sides of a support member, not shown, for the solar cell 2.

The electrically conductive adhesive film 15, carried by a support member of, for example, PET, is wrapped around each of the supply reels 18. The electrically conductive adhesive film 15 is guided, along with the support member, to a position facing the front side surface or the reverse side surface of the solar cell 2 via a capstan roll and a pinch roll. The electrically conductive adhesive film is then temporarily affixed by the temporary bonding heads 17 on the bus-bar electrode 11 of the solar cell 2 or on the connecting part 13a of the Al reverse surface side electrode 13.

The temporary bonding heads 17 are provided for performing up-and-down movement at a position of facing the front or reverse side surface of the solar cell 2 carried by the support member. When the solar cell 2 is placed on the support member, and the electrically conductive adhesive film 15 travels over the bus-bar electrode 11 or over the connecting part 13a of the reverse surface side Al electrode 13, the temporary bonding heads 17 thermally pressures the electrically conductive adhesive film 15 onto the front and reverse side surfaces of the solar cell 2 via the support member. At this time, the temporary bonding heads 17 heats the electrically conductive adhesive film 15 to such a temperature that fluidizes the organic resin binder of the electrically conductive adhesive film 15 without producing ultimate curing. This generates an adhesive force to temporarily bond the electrically conductive adhesive film 15 to the solar cell 2.

The support member that carries the electrically conductive adhesive film 15 is released at the time of the temporary bonding of the electrically conductive adhesive film 15. The so released support member is transported further by the capstan roll and the pinch roll for disposal.

### [Process of connection of the solar cell 2]

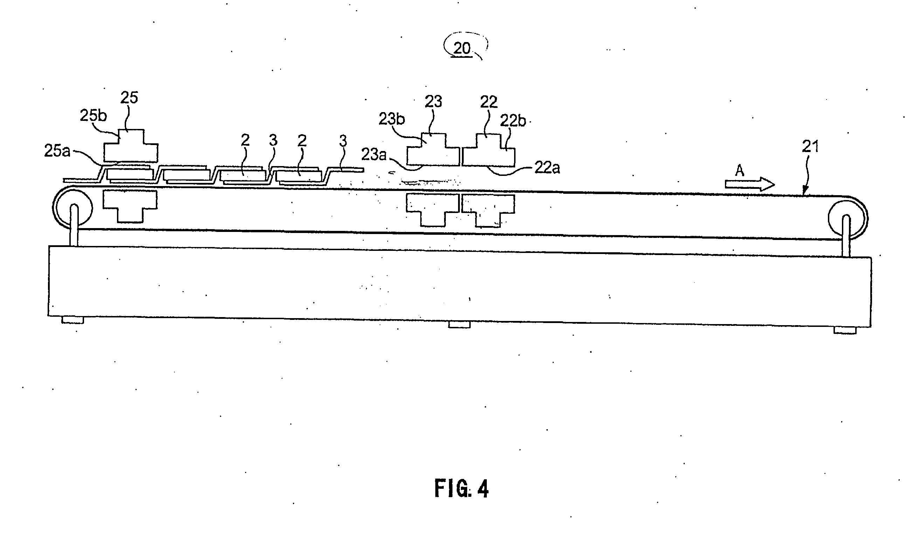

A plurality of solar cells 2 are arrayed on a solar cell interconnection device 20, and a tab wire 3 is temporarily pressure bonded by a temporary pressure bonding head 25 onto the electrically conductive adhesive film 15. At this time, one end 3a of the tab wire 3 is temporarily pressure bonded, via a non-cured electrically conductive adhesive film 15, to the bus-bar electrode 11, formed on the surface of the leading side solar cell 2a, as shown in Figs.2 and 4. The opposite end 3b of the tab wire 3 is temporarily pressure bonded, via another non-cured electrically conductive adhesive film 15, to a connecting part 13a of the reverse surface side Al electrode 13 of the other solar cell 2b on the trailing side of the solar cell 2a. Analogously, one end 3a of another tab wire 3 is temporarily pressure bonded via still another non-cured electrically conductive adhesive film 15 to the bus-bar electrode 11 formed on the surface of the above mentioned other solar cell 2b. The opposite end 3b of the other tab wire 3 is temporarily pressure bonded via a further non-cured electrically conductive adhesive film 15 to a connecting part 13a of the reverse surface side Al electrode 13 of a solar cell 2c on the trailing side of the solar cell 2b. In this manner, a plurality of neighbored solar cells 2 are interconnected in tandem by a plurality of the tab wires 3.

The tab wires 3, interconnecting the solar cells 2a, 2b, 2c, ··· in cascade, are thermally pressure bonded in sequence by the heating pressuring head 22 to cure the electrically conductive adhesive films 15 to ultimately pressure bond the tab wires 3 to the solar cells 2. At this time, in the present exemplary embodiment, a heat dissipating head 23, operatively linked with the heating pressuring head 22, thrusts the tab wire 3, temporarily pressure bonded to the other solar cell 2 on the trailing side of the solar cell 2 which is currently pressured by the heating pressuring head 22. It is thus possible to prevent that heat is transmitted from the heating pressuring head 22 to the electrically conductive adhesive films 15, temporarily affixed to the trailing side neighbored solar cell 2, thereby preventing the progressing of the curing reaction.

The solar cell interconnection device 20, interconnecting the solar cells 2, will now be described in detail. The solar cell interconnection device 20 includes a support unit 21 that supports a train of a plurality of solar cells, paired heating pressuring heads 22 and paired heat dissipating heads 23. The heating pressuring heads 22 thrust the tab wires 3, under heating, against the bus-bar electrode 11 of the leading side solar cell 2 and against the connecting part 13a of the reverse surface side A1 electrode 13 of the next following solar cell 2, via the electrically conductive adhesive films 15. The heat dissipating heads 23 thrust the tab wire 3, temporarily pressure bonded to the neighboring solar cell 2, which is on the trailing side of the solar cell 2 currently thrust by the heating pressuring head 22. The paired heating pressuring heads 22 and the paired heat dissipating heads 23 are arranged above and below the upper running part of the support unit 21. The solar cell interconnection device 20 also includes the temporary pressure bonding heads 25 on an upstream side of the heating pressuring heads 22 and the heat dissipating heads 23 relative to the transport direction of the solar cells 2 indicated by an arrow A of Fig.4. Temporary pressure bonding heads 25 operate to temporarily pressure bond the tab wires 3 to the bus-bar electrode 11 of the solar cell and to the connecting part 13a of the reverse surface side Al electrode 13 of each solar cell 2 via the electrically conductive adhesive films 15.

The support unit 21 supports and transports the solar cells 2 to the positions of registration of the upper and lower pair heat pressuring heads 22 and the upper and lower pair heat dissipating heads 23. In the present exemplary embodiment, the support unit is arranged as a belt conveyor adapted for travelling on a plurality of rolls to transport the solar cells 2. A plurality of the solar cells 2 is placed on the support unit 21 to form a train of the solar cells. The solar cells of the train are then transported to positions in register with the temporary pressure bonding heads 25, as later explained, the heating pressuring head 22 and the heat dissipating head 23. The support unit 21 may be so constructed and designed that support means, not shown, are provided at such positions that the solar cells are in register with the temporary pressure bonding heads 25, heating pressuring head 22 and the heat dissipating head 23. The solar cells may then be located in stability in correct positions relative to the heads 21, 22 and 25 as variations in the pressuring force are suppressed from being produced.

The heating pressuring head 22 includes a pressuring surface 22a that thrusts the tab wire 3 and a head main 22b in which there is provided on board a heater, herein not shown. The heating pressuring head 22 thrusts the pressuring surface 22a, heated at a pre-set temperature of curing of the organic resin binder of the electrically conductive adhesive film 15, against the tab wire 3 at a pre-set pressure and for a pre-set time duration. By so doing, the anisotropic electrically conductive adhesive film 15 may be cured with the electrically conductive particles in a collapsed state.

The heat dissipating head 23 is provided adjacent to the heating pressuring head 22 on an upstream side thereof along the transport direction of the solar cells 2. The heat dissipating head 23 includes a head main 23b provided with a pressuring surface 23a that thrusts the tab wire 3. The heat dissipating head 23 absorbs heat transmitted from the heating pressuring head 22 to the tab wire 3 to dissipate the heat absorbed. It is thus possible to prevent the curing reaction of the organic resin binder from progressing before the non-cured electrically conductive adhesive film 15 enters into the ultimate pressure bonding phase.

The head main 23b is formed of a material of high heat conductivity and is capable of efficiently absorbing and dissipating the heat of the tab wire. It is also possible that the head main 23b has on board a cooling mechanism, not shown, and is formed of a material of low thermal conductivity to help maintain the cooling effect.

The temporary pressure bonding head 25 heats the tab wire 3 at such a temperature as not to permit the progressing of the curing reaction of the electrically conductive adhesive film 15. It is thus possible to temporarily pressure bond the tab wire 3 onto the bus-bar electrode 11 and the connecting part 13a of the reverse surface side Al electrode 13 in advance of the ultimate pressure bonding step. The temporary pressure bonding head 25 includes a pressuring surface 25a that thrusts the tab wire 3 and the header main 25b having on board a heater, herein not shown.
The heating pressuring head 22, heat dissipating head 23 and the temporary pressure bonding head 25 are actuated by head driving units which are herein not shown. The head driving units are provided in the heads 22, 23 and 25 separately, or are comprised of first and second head driving units. The first head driving unit causes the operation the heating pressuring head 22 and the heat dissipating head 23 in synchronization with each other, while the second head driving unit 25 causes the operation of the temporary pressure bonding head 25.

The head driving units actuate the upper and lower pair heating pressuring heads 22, upper and lower pair heat dissipating heads 23 and the upper and lower pair temporary pressure bonding heads 25, provided on upper and lower sides of an upper running part of the support unit 21, in synchronization with each other. The head driving units actuate the upper and lower pair heads so that the heads approach to or are receded away from both surfaces of the solar cells 2. The head driving units actuate respective head mains 22b, 23b and 25b to thrust the tab wire 3 for a pre-set time duration at a pre-set pressure.

The head driving units control the driving of the heaters provided on board the head main 22b of the heating pressuring head 22 and the head main 25b of the temporary pressure bonding head 25. During the temporary pressure bonding and the ultimate pressure bonding of the tab wires 3, the head driving units cause the operation of the heaters provided on board the head mains 22b, 25b to heat the heaters to a pre-set temperature.

### [Process of interconnection by tab wire 3]

The process of producing the solar cell module 1 using the solar cell interconnection device 20 will now be described. Initially, the solar cell 2 is produced. In producing the solar cell 2, any of a large variety of photovoltaic conversion elements 10 may be used. For example, in producing a crystalline silicon based solar cell module, a single crystal silicon photovoltaic conversion element or a polycrystalline photovoltaic conversion element may be used. In producing a thin film silicon solar cell, a photovoltaic conversion element, obtained on layering a cell of amorphous silicon and a cell of microcrystalline silicon or of amorphous silicon germanium, may be used.

In the solar cell 2, a finger electrode 12 and a bus-bar electrode 11 are formed by coating and sintering an Ag paste on a surface of the photovoltaic conversion elements 10 which is to become the light receiving surface of the photovoltaic conversion elements 10. A reverse surface side Al electrode 13, having a connecting part 13a to the tab wire 3, is formed on a reverse surface of the photovoltaic conversion element by, for example, Al screen printing.

Then, in the photovoltaic conversion element 10, an electrically conductive adhesive film 15 is bonded to the bus-bar electrode 11 on its front surface and to the connecting part 13a on its reverse surface. A tab wire 3 is then temporarily pressure bonded to the electrically conductive adhesive film 15.

In the process of bonding the electrically conductive adhesive film 15, each solar cell 2 is placed on the bonding device 16 for the electrically conductive adhesive film 15. The electrically conductive adhesive film 15, reeled out in a non-cured state from the supply reels 18, is temporarily bonded by the temporary bonding heads 17 to the bus-bar electrode 11 and to the connecting part 13a of the reverse surface side Al electrode 13 on the solar cells 2. At this time, the temporary bonding heads 17 heat for a pre-set time duration, such as 1 to 5 sec, at such a temperature that fluidizes the electrically conductive adhesive film 15 but does not cause its ultimate curing.

Each solar cell 2, to which has been temporarily bonded the electrically conductive adhesive film 15, is placed on the support unit 21 of the solar cell interconnection 20 in the sequence of the cascaded connection. The tab wire 3 is temporarily pressure bonded via the electrically conductive adhesive film 15 to the bus-bar electrode 11 and to the connecting part 13a of the reverse surface side Al electrode 13. At this time, one end 3a of the tab wire 3 is bonded on the bus-bar electrode 11 formed on the front surface of the leading solar cell. On the other hand, the opposite side 3b of the tab wire is bonded on the connecting part 13a of the reverse surface side Al electrode 13 formed on the reverse side surface of the next following trailing side solar cell 2b.

The tab wire 3 is pressured against the pressuring surface 25a by the pair temporary pressure bonding heads 25 performing a synchronized up-and-down movement. The pair temporary pressure bonding heads 25 are provided above and below the upper running part of the support unit 21, as shown in Fig.4. At this time, the pair temporary pressure bonding heads 25 thrust the tab wire 3 by the pressuring surface 25a of the heads main 25b heated to such a temperature as not to produce the curing reaction of the electrically conductive adhesive film 15. Hence, the binder resin is fluidized and demonstrates an adhesive power. The electrically conductive adhesive film 1 S is thus able to temporarily affix the tab wire 3 to the bus-bar electrode 11 and to the connecting part 13a of the reverse surface side Al electrode 13.

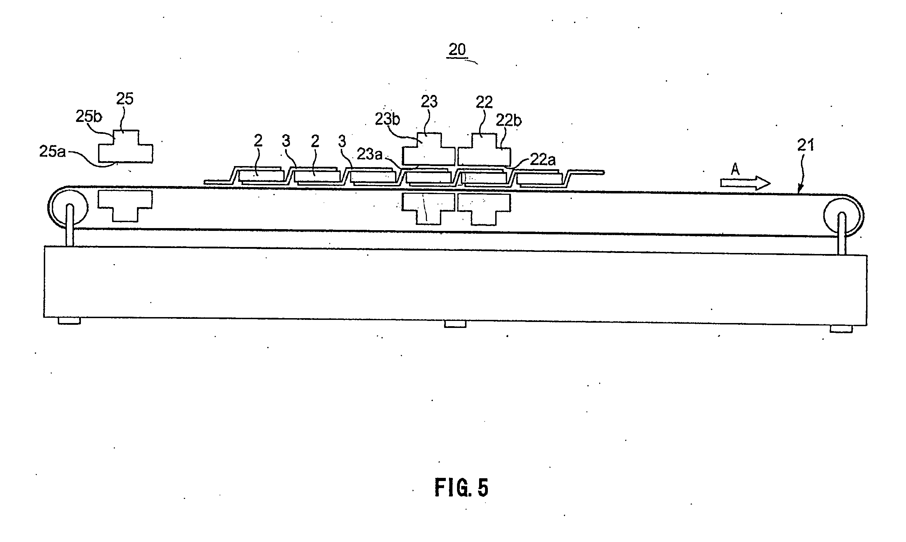

The plurality of the solar cells 2, to which the tab wires have been affixed temporarily, are then transported to directly below the heating pressuring head 22 and the heat dissipating head 23, and are supported in position, as shown in Fig.5. The tab wires 3 are then pressured by the heating pressuring head 22 and the heat dissipating head 23.

At this time, the tab wire 3 is thrust at a pre-set pressure via the pressuring surfaces 22a of the pair heating pressuring heads 22 against the leading side solar cell 2, one of the solar cells 2, as a result of the pair heating pressuring heads 22 being raised and lowered in synchronization with each other. The pair heating pressuring heads 22 are provided above and below the upper running part of the support unit 21. The pair heating pressuring heads 22 are heated to such a pre-set temperature as to cause curing of the electrically conductive adhesive film 15. Hence, the binder resin in the electrically conductive adhesive film 15 is thermally cured to electrically and mechanically interconnect the tab wire 3 on one hand and the bus-bar electrode 11 or the connecting part 13a of the reverse surface side Al electrode 13 on the other.

The tab wire 3 temporarily bonded to the solar cell 2b, next following the leading side solar cell 2a, is thrust against the pressuring surface 23a of heat dissipating head 23 provided above and below the upper running part of the support unit 21, as a result of the synchronized up-and-down movement of the pair heat dissipating head 23. Note that the head main 23b of the heat dissipating head 23 is formed of a material having high thermal conductivity. Hence, the heat transmitted to the other end 3b of the tab wire 3 as a result of the one end 3a of the tab wire 3, temporarily affixed to the leading side solar cell 2a, being pressured by the heating pressuring head 22, may be efficiently absorbed and dissipated. It is thus possible to prevent the electrically conductive adhesive film 15 of the trailing side solar cell from being heated via the tab wire 3 extending to the leading side solar cell 2a, and hence to prevent progressing of the curing reaction at the opposite end 3b of the tab wire 3 before thermal pressuring of the electrically conductive adhesive film by the pressuring head 22. Hence, the connection reliability may be maintained at the opposite end of the tab wire 3.

It is noted that the heat dissipating heads 23 are raised and lowered by the head driving units with the raising/ lowering of the heating pressuring heads 22. For example, the heat dissipating head 23 is connected to the heating pressuring head 22 by a connector, not shown, to perform up-and-down movement in unison. Hence, the heat dissipating head 23 thrusts the opposite end 3b of the tab wire 3 at the same time as the heating pressuring head 22 thrusts its one end 3a. Similarly, the heat dissipating head 23 is separated away from the opposite end 3b of the tab wire 3 at the same time as the heating pressuring head 22 is separated away from the one end 3a of the tab wire 3. Thus, as long as the one end 3a of the tab wire 3 is heated and thrust by the heating pressuring head 22, the heat dissipating head 23 thrusts the opposite end 3b of the tab wire 3. It is thus possible that the non-cured electrically conductive adhesive film 15 is prevented against prematurely cured by the tab wire 3.

The heat dissipating head 23 may be operated by the head driving unit so that it will thrust the opposite end 3b of the tab wire 3 before the heating pressuring head 22 thrusts the one end 3a of the tab wire and so that it will be separated away from the opposite end 3b of the tab wire after separation of the heating pressuring head 22 away from the one end 3a of the tab wire 3. By so doing, the heat dissipating head 23 continues thrusting the opposite end 3b of the tab wire 3 not only during the time when the one end 3a of the tab wire 3 is heated and pressured by the heating pressuring head 22 but also during some time before as well as after the time the one end of 3a the tab wire 3 is so heated and pressured. It is thus positively possible to prevent the heat applied to the one end 3a of the tab wire 3 from being transmitted to the opposite end 3b to prevent the non-cured electrically conductive adhesive film 15 from being prematurely cured via the tab wire 3.

In the interconnection device 20, if once the tab wire 3 is ultimately bonded by the heating pressuring head 22 to the leading side solar cell 2, the paired heating pressuring heads 22 are separated away from the tab wire 3 by the head driving unit. The pair heat dissipating heads 23 are also separated away from the tab wire 3 of the trailing side solar cell 2. The solar cell interconnection device 20 then transports the solar cell 2, thrust by the heat dissipating heads 23, via the support unit 21, to directly below the paired heating pressuring head 22, while also transporting a further trailing side solar cell 2 to directly below the heat dissipating head 23.

In this manner, the interconnection device 20 transports the solar cells 2 one by one to directly below the heat dissipating head 23 and the heating pressuring head 22 to sequentially interconnect the tab wires 3 to the bus-bar electrode 11 and to the connecting part 13a of the reverse surface side Al electrode 13. At the same time, the neighbored solar cells 2 are interconnected in tandem with each other.

According to the present invention, the electrically conductive adhesive film 15 may not be used, in which case a paste-like electrically conductive adhesive may be coated to interconnect the tab wires 3 to the electrodes 11, 13.

Also, in the solar cell 2, it is not always necessary to provide the bus-bar electrode 11. If the bus-bar electrode is not provided, in the solar cell 2, the current in the finger electrode 12 is collected by the tab wire 3 that intersects the tab wire 3.

It is noted that temporary affixing of the electrically conductive adhesive film 15 and temporary pressure bonding of the tab wire 3 may be accomplished by temporary pressure bonding a layered film to the bus-bar electrode 11 and to the connecting part 13a. This layered film is composed by an electrically conductive adhesive film layered on one side of the tab wire 3, and may be wrapped like a reel so that it may be paid out and temporarily pressure bonded by the bonding device 16 to the solar cell 2.

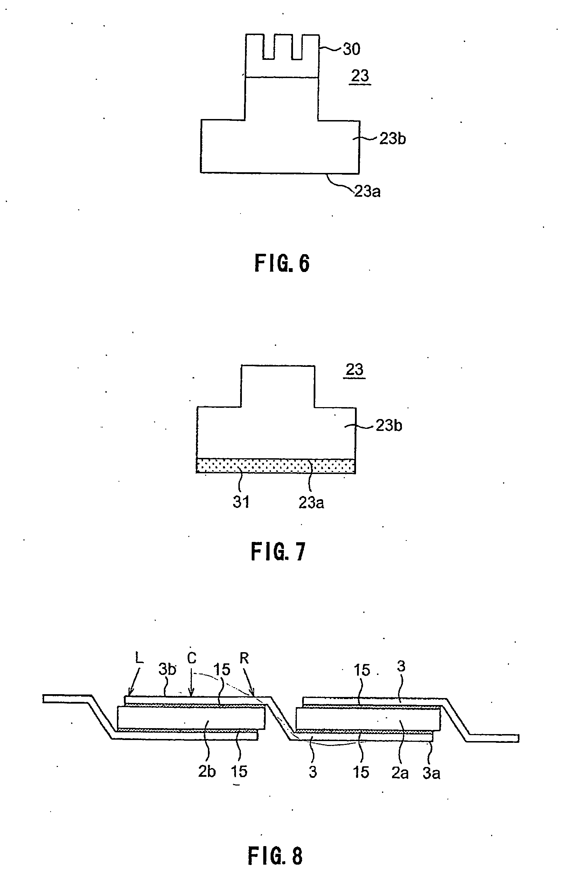

The head main 23b of the heat dissipating head 23 may also be provided with a heat sink 30, as shown in Fig.6. By providing the interconnection device 20 with the heat sink 30, it is possible to improve and maintain the beneficent effect of absorption and dissipation of the heat transmitted to the opposite end of the tab wire by the heat dissipating head 23.

An elastic member 31 may be provided on the pressuring surface 23a of the head main 23b of the heat dissipating head 23, as shown in Fig.7. By providing the interconnection device 20 with the elastic member 31 of, for example, rubber of high thermal conductivity, crests or recesses on the tab wire 3 may be followed up to increase the contact area between the pressuring surface 23a and the opposite end 3b of the tab wire 3 to assure more intimate contact therebetween. Moreover, it is possible to positively absorb and dissipate heat transmitted to the opposite end 3b of the tab wire 3 to prevent curing of non-cured electrically conductive adhesive film 15.

### Example 1

Several Examples of the present invention will now be described. In Example 1, at the time of the ultimate pressure bonding of the leading side solar cell 2, the heat from the tab wire 3 temporarily pressure bonded to the next following solar cell 2 was dissipated by the heat dissipating head 23, the head main 23b of which was provided with the heat sink 30. In Example 2, at the time of the ultimate pressure bonding of the leading side solar cell 2, the heat from the tab wire 3 temporarily pressure bonded to the next following solar cell was dissipated by the heat dissipating head 23, the head main 23b of which was provided with the heat sink 30 and the pressuring surface 23a of which was provided with the elastic member 31. In Example 3, at the time of the ultimate pressure bonding of the leading side solar cell 2, the heat was dissipated from the tab wire 3 temporarily pressure bonded to the next following solar cell 2 by the heat dissipating head 23 provided with neither the heat sink 30 nor the elastic member 31. In a Comparative Example, ultimate pressure bonding of the tab wire 3, temporarily pressure bonded to the next following solar cell 2, was carried out just with the use of the heating pressuring head 22, without using the heat dissipating head 23.

As for the materials of the evaluation samples for the Examples and the Comparative Example, a 6-inch polycrystalline Si cell was used as the solar cell. A copper wire 2 mm width by 0.1 mm thickness, coated with a solder, was used as tab wire. The electrically conductive adhesive film sized 2 mm by 150 mm was used.

As for the conditions for pressure bonding by the heating pressuring head 22, pressure bonding was carried out for 15 sec at 180°C at 2 MPa. The heat dissipating head 23 was run in synchronization with the heating pressuring head 22 and brought into and out of contact with the tab wire 3 simultaneously with the heating pressuring head 22.

As for the evaluation samples, a string composed by two solar cells 2a, 2b interconnected by the tab wire 3 was prepared. Two such evaluation samples were provided for each Example and the Comparative Example. In one of the samples, just the solar cell 2a was ultimately bonded by the heating pressuring head 22, and curing reactivity of different portions (a left end L, a center part C and a right end R) of the solar cell 2b was measured. For the other of the samples, ultimate pressure bonding by the heating pressuring head 22 was carried out in the sequence of the solar cells 2a and 2b, after which the adhesion strength at each of different portions (a left end L, a center part C and a right end R) of the solar cell 2b was measured. Then the curing reactivity and interconnection reliability were also evaluated.

For the electrically conductive adhesive film to exhibit stabilized connection performance, it is required that the curing reactivity is in excess of 80%. To find the curing reactivity, IR measurement was made of samples before the curing reaction and those after the curing reaction. The ratio of peak strengths of epoxy groups in a chart obtained was found in terms of the proportion of residual epoxy groups. This proportion is then subtracted from 1 (unity) to yield the curing reactivity.

Regarding the evaluation of the interconnection reliability, the connection resistance of the tab wire 3 connected to the solar cell 2b was measured. The samples with the resistance value less than 40 mΩ was marked ⊚ and those with the resistance value not less than 40 mΩ and less than 45 mΩ were marked ○. The samples with the resistance value not less than 45 mΩ and less than 50 mΩ were marked Δ and those with the resistance value not less than 50 mΩ were marked X. Measurement and evaluation were made directly after connection of the tab wire 3 (initial values) and after environment test (500 hours under high temperature of 80°C and high humidity of 80%).

Table 1 below shows measured results. Note that, in Table 1, a configuration of the connection method A is such a one where the solar cell 2b is pressured by the heat dissipating head 23 in the course of the ultimate pressure bonding of the solar cell 2a and is subsequently transported to a site directly below the heating pressuring head 22 where the cell is to undergo the ultimate pressure bonding. A configuration of the connection method B is such a one where the solar cell 2b is not pressured by the heat dissipating head 23 in the course of the ultimate pressure bonding of the solar cell 2a and is subsequently transported to a site directly below the heating pressuring head 22 where the cell is to undergo the ultimate pressure bonding.

**[Table 1]**

| | | | Ex.1 | Ex.2 | Ex.3 | Comp. Ex1 |
|---|---|---|---|---|---|---|
| Configurations of connecting method | | | A | A | A | B |
| Pressuring by heat dissipating head | | | Yes | Yes | Yes | / |
| Setting elastic member on heat dissipating head | | | / | Yes | / | / |
| Setting heat sink on heat dissipating head | | | Yes | Yes | / | / |
| | | | | | | |
| Before thermal pressure bonding | Reactivity (%) | L | less than 5 | less than 5 | less than 5 | less than 5 |
| | | C | less than 5 | less than 5 | less than 5 | 10 |
| | | R | 10 | less than 5 | 220 | 35 |
| After thermal pressure bonding | Adhesion strength (N/mm²) | L | 4 | 4 | 4 | 4 |
| | | C | 4 | 4 | 4 | 3 |
| | | R | 3 | 4 | 3 | 2 |
| | Reactivity (%) | | not less than 80 | not less than 80 | not less than 80 | not less than 80 |
| | Connection reliability (initial) | | ⊚ | ⊚ | ⊚ | Δ |
| | Connection reliability (80°C, 80%RH, 500hrs) | | ⊚ | ⊚ | ○ | x |

The reactivity at various parts of the solar cell 2b after the ultimate pressure bonding of the solar cell 2a and before the ultimate pressure bonding of the solar cell 2b was checked in Table 1. It is seen from Table 1 that, while the reactivity at the rightmost end R of the tab wire 3, closest to the one end of the tab wire pressured against the heating pressuring head 22 under heating, is as low as 20% in Example 3, it is 35% in the Comparative Example. This indicates that, while the curing reaction of the electrically conductive adhesive film is not going on in the Example, it is going on with the Comparative Example where there is not provided the heat dissipating head 23.

The adhesion strength of the solar cells 2a and 2b after the ultimate pressure bonding was also checked. It was seen that, while the adhesion strength at the rightmost end R is 3 (N/mm²) in Example 3, it is 2 (N/mm²) in the Comparative Example. It was also seen that the adhesion strength at the center C was also higher in Example than in Comparative Example.

After the samples were subjected to environmental testing, the difference in the evaluation of the connection reliability of the Examples and the Comparative Example was more pronounced. This indicates that high connection reliability may be maintained in the Examples where the tab wire was pressured by the heat dissipating head 23 to suppress the curing reaction of the electrically conductive adhesive film before it is subjected to the ultimate pressure bonding process.

In the case of the samples of the Examples, the heat dissipating head 23 of Example 2 is provided not only with the heat sink 30 but also with the elastic member 31. As a result, sufficient heat was dissipated, such that, even at the rightmost end R of the solar cell 2b about to be subjected to thermal pressure bonding, the reactivity was less than 5%. That is, in the heat dissipating head 23 of Example 2, an excellent heat dissipation effect could be demonstrated, while connection reliability after the ultimate pressure bonding was also high.

## Claims

1. A method for producing a solar cell module in which a front surface electrode of a given solar cell and a reverse surface electrode of another solar cell are interconnected by a tab wire affixed to the front surface electrode via a thermally curable electrically conductive adhesive film and affixed to the reverse surface electrode via another thermally curable electrically conductive adhesive film, comprising
a placing step of placing the tab wire via the electrically conductive adhesive films on the front surface electrode and the reverse surface electrode;
a thermal pressuring step of pressuring a first adherent portion of the tab wire placed on one of the electrodes via the electrically conductive adhesive film in a non-cured state, by a first pressuring head having a heating/ pressuring unit; and
a heat dissipating step of pressuring a second adherent portion of the tab wire, placed on the other electrode via the other electrically conductive adhesive film in a non-cured state, by a second pressuring head having a heat dissipating unit.

2. The method for producing a solar cell module according to claim 1, wherein
the thermal pressuring step and the heat dissipating step are interlinked with each other and carried out for the given solar cell and the other solar cell supported adjacent to each other.

3. The method for producing a solar cell module according to claim 2, wherein
the second pressuring head thrusts the second adherent portion as long as the first pressuring head thrusts the first adherent portion under heating.

4. The method for producing a solar cell module according to claim 3, wherein
the first pressuring head and the second pressuring head are interconnected by a connector.

5. The method for producing a solar cell module according to claim 3, wherein
the second pressuring head thrusts the second adherent portion before the first pressuring head thrusts the first adherent portion; the second pressuring head being separated from the second adherent portion after the first pressuring head is separated from the first adherent portion.

6. The method for producing a solar cell module according to any one of claims 1 to 5, wherein
the second pressuring head is provided with a heat sink.

7. The method for producing a solar cell module according to claim 1, wherein
a pressuring surface of the second pressuring head, thrusting the second adherent portion, is provided with an elastic member.

8. An apparatus for interconnecting a plurality of solar cells, comprising
a support unit that supports a plurality of solar cells in cascade;
a first pressuring head including a heating/ pressuring unit that heats/ thrusts one end of a tab wire temporarily affixed to a front surface electrode or a reverse surface electrode of a given solar cell via an electrically conductive adhesive film in a non-cured state; and
a second pressuring head including a heat dissipating unit that thrusts the opposite end of the tab wire temporarily affixed via another electrically conductive adhesive film in a non-cured state to a front surface electrode or a reverse surface electrode of another solar cell neighbored to the given solar cell to dissipate the heat.

9. A solar cell module produced using the methods according to any of claims 1 to 7.
